# EUROPEAN PATENT APPLICATION

(11) **EP 4 280 370 A1**
(43) Date of publication of application: **22.11.2023**
(21) Application number: 22916614.5
(22) Date of filing: 22.12.2022
(51) Int. Cl.: H01M 50/579, H01M 50/578, H01M 8/04313, H01M 50/30, H01M 10/48, H01M 10/052, H01M 50/105, H01M 50/204

(54) **METHOD AND APPARATUS FOR TRANSMITTING AND RECEIVING SIGNAL IN COMMUNICATION SYSTEM**

(30) Priority: 30.12.2021 KR 20210191987; 21.12.2022 KR 20220180764
(71) Applicant: LG Energy Solution, Ltd., Seoul 07335 (KR)
(72) Inventor: HAHN, Gene Back, Hwaseong-si, Gyeonggi-do 18280 (KR); SUH, Young Kil, Hwaseong-si, Gyeonggi-do 18280 (KR); HONG, Ui Hyun, Hwaseong-si, Gyeonggi-do 18280 (KR); KIM, Bum Jun, Seoul 08826 (KR); KWON, Jung Hyeon, Seoul 08826 (KR); CHOI, Wan, Seoul 08826 (KR)
(74) Representative: Goddar, Heinz J.
(86) International application number: PCT/KR2022/021099
(87) International publication number: WO 2023/128472

(57) **Abstract**

Disclosed herein provides a battery module configured to recognize the time when the volume change of a battery cell converts again from a stagnant state to an increasing state as a gas venting risk point, a battery pack, and a method for detecting a gas venting risk point.

The present invention can recognize the risk of gas venting immediately before a gap is formed in a sealing part of a pouch-type battery cell, thereby having an effect of improving the safety of a battery module and a battery pack to which particularly large-capacity battery cells are applied.

## Description

### [Technical Field]

This application claims the benefit of priority based on Korean Patent Application No. 10-2021-0191987 filed on December 30, 2021 and Korean Patent Application No. 10-2022-0180764 filed on December 21, 2022.

The present invention relates to a battery module, a battery pack, and a method for detecting gas venting in which safety is improved by recognizing gas venting at an early stage based on a volume change behavior of a battery cell.

### [Background Technology of the Invention]

Recently, secondary batteries capable of charging and discharging have been widely used as energy sources of wireless mobile devices. In addition, the secondary battery has attracted attention as an energy source of electric vehicles, hybrid electric vehicles, and the like, which are proposed as a solution for air pollution and the like of existing gasoline vehicles and diesel vehicles using fossil fuels. Accordingly, the types of applications using the secondary battery have diversified due to the advantages of the secondary battery, and it is expected that the secondary battery will be applied to many fields and products in the future.

These secondary batteries can be classified into lithium-ion batteries, lithium-ion polymer batteries, lithium polymer batteries, etc. depending on the composition of an electrode and an electrolyte, and among them, there has been an increase in the use of lithium-ion polymer batteries, which are less likely to leak an electrolyte and easy to manufacture. In general, depending on the shape of a battery case, secondary batteries can be classified into a cylindrical battery and a prismatic battery in which an electrode assembly is embedded in a cylindrical or a prismatic metal can, and a pouch-type battery in which an electrode assembly is embedded in a pouch-type case made of an aluminum laminate sheet.

Among them, an enlargement in the area of the case due to the high capacity of the battery and processing into thin materials are attracting much attention, and accordingly, the use of a pouch-type battery with a structure in which a stack type or a stack/folding type electrode assembly is embedded in a pouch-type battery case made of an aluminum laminate sheet is gradually increasing due to reasons such as low manufacturing cost, small weight, easy shape transformation, etc.

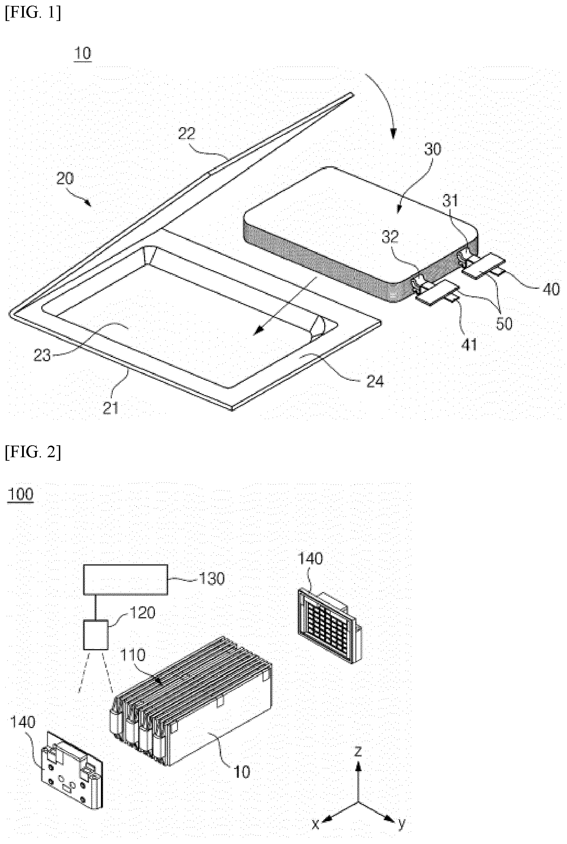

FIG. 1 is a schematic diagram of a pouch-type battery cell.

A pouch-type battery cell 10 consists of a structure in which two electrode leads 40, 41 electrically connected to positive electrode and negative electrode tabs 31, 32 of an electrode assembly 30 composed of a positive electrode, a negative electrode, and a separator disposed therebetween inside a pouch-type battery case 20 are sealed so that they are exposed to an outside.

The battery case 20 may be composed of a case body 21 including a concave accommodating part 23 in which the electrode assembly can be settled and a cover 22 integrally connected to the body 21.

In a stack type electrode assembly 30, a plurality of positive electrode tabs and a plurality of negative electrode tabs 32 are fused and coupled to the electrode leads 40, 41, respectively. In addition, the electrode leads 40, 41 are located at the upper end 24 of the case body 21 and the upper end of the cover 22 and an insulating film 50 is attached thereto to prevent a short circuit.

When the pouch-type battery cell 10 is sealed, the case body 21 and the cover are heat-compressed together using a sealing member in a state in which they are in contact with each other, and a polymer resin constituting the innermost coating layer of the aluminum laminate sheet constituting the body 21 and the cover 22 is melted during heat-compression, and the body and the cover become fused. And the portion heat-fused by a heat-compression of the sealing member is called a sealing part.

Meanwhile, during the usage of the pouch-type battery, deterioration of the battery occurs as charging and discharging are repeated, and when there is a sudden exposure to high temperature, internal gas is generated in the battery, and the gas generated as such fills up the sealed surplus space of the battery, causing the battery to swell. In addition, the internal pressure caused by the internal gas acts on the sealing part of the pouch-type secondary battery, weakening the adhesive strength of the sealing part, and when this state continues for several weeks or months, a gap may be formed in the sealing part.

Accordingly, the gas inside the battery is vented to an outside of the battery through the gap in the sealing part, the electrolyte inside the battery is volatilized through the gap in the sealing part, and oxygen or moisture from an outside flows into the battery cell, thereby causing problems to the battery cell performance. Also, leakage of the electrolyte may cause a safety problem in an external circuit.

Korean Patent Laid-open Publication No. 10-2021-0073898 discloses a battery module including a control part that detects pressure applied to the case when the volume of the cell stack expands, and determines an inflection point of the pressure value as the time of the occurrence of case deformation. However, although the above technology is useful for detecting the time of case deformation, there is a limitation in that the time of gas venting of the battery cell cannot be detected at an early stage.

Therefore, there is a need to develop a technology for a battery module and a battery pack that can detect gas venting in battery cells at an early stage.

### [Detailed description of the invention]

### [Technical Problem]

In terms of a battery module, an object of the present invention is to provide a battery module and a battery pack capable of recognizing gas venting in advance or at an early stage.

In addition, in terms of a pouch-type secondary battery, the present invention is directed to provide a method for early detection of a gas venting point.

### [Technical Solution]

According to an embodiment of the present invention, a battery module includes: a battery cell stack in which a plurality of battery cells is stacked; a measuring part including a volume measuring means for observing a volume change of a battery cell, and transmitting the observed volume change as a signal; and a control part receiving a signal from the measuring part, creating a time-volume profile representing volume change over time based on the received signal, and recognizing the risk of gas venting, wherein the control part is configured to recognize the time when the volume change in the time-volume profile converts again from a stagnant state to an increasing state as a gas venting risk point.

In an exemplary embodiment of the present invention, the time-volume profile may be divided into a first section in which the volume increases, a second section in which the volume change stagnates following the first section, and a third section in which the volume change increases again following the second section, wherein the control part may recognize the starting point of the third section as a gas venting risk point.

In an exemplary embodiment of the present invention, the control part may be configured to create the time-volume profile based on a volume when a state of charge (SOC) of a battery cell satisfies a set SOC value.

In an exemplary embodiment of the present invention, the control part may be configured to correct a volume Vm measured at an actual volume measurement temperature Tm with a volume Vn at a standard temperature Tn, and create the time-volume profile based on the corrected volume Vn.

In an exemplary embodiment of the present invention, the battery cell may be a pouch-type battery cell having a structure in which an electrode assembly including a positive electrode, a negative electrode, and a separator is accommodated inside a battery case of a laminate sheet, and the battery case is sealed by heat fusion.

In an exemplary embodiment of the present invention, the volume measuring means may include a thermal imaging camera configured to perform a vision inspection on a sealing part in which the battery case is heat-fused.

A battery module according to an exemplary embodiment of the present invention may further include a module case which has an accommodation space corresponding to the shape and size of a battery cell stack inside and is hexahedron-shaped.

In an exemplary embodiment of the present invention, the volume measuring means may either be a strain gauge or a pressure sensor.

In an exemplary embodiment of the present invention, the control part may include a calculation part for estimating a signal received from the measuring part as a volume change.

In an exemplary embodiment of the present invention, the strain gauge may be attached to a sealing part in which a battery case is heat-fused.

In an exemplary embodiment of the present invention, the measuring part may further include a voltage sensor for measuring the voltage of a battery cell; and a temperature sensor for measuring the temperature of the battery cell.

In an exemplary embodiment of the present invention, the control part may be configured to generate a warning signal to secure the safety of the battery module when recognizing the risk of gas venting, and the warning signal may be any one or more of (1) an operation control signal for stopping the operation of the battery module, (2) a recognition signal that visually or aurally makes the user or the mechanic of a device equipped with the battery module aware of the danger.

According to another exemplary embodiment of the present invention, a battery pack including one or more battery modules as a unit module is provided.

According to another exemplary embodiment of the present invention, a detection method of gas venting risk point for detecting a gas venting risk of a pouch-type battery cell includes: a data collection process S10 of measuring a volume change of the battery cell and a state of charge (SOC) of the battery cell over time; creating a time-volume profile S20 in which volume is made to correspond with the passage of time; and determining S30 the time when the volume change in the time-volume profile converts again from a stagnant state to an increasing state as a gas venting risk point.

In an exemplary embodiment of the present invention, creating a time-volume profile S20 may include: selecting S21 a measured volume data of a battery cell when a state of charge (SOC) of a battery cell is a set SOC; and creating a time-volume profile S22 by matching the selected volume data to the passage of time.

In an exemplary embodiment of the present invention, the data collection process S10 may further include measuring a temperature of a battery cell, and creating the time-volume profile S20 further includes correcting a volume S23 in which the selected volume data is corrected to a volume at the standard temperature Tn when the volume measurement temperature Tm, which is the basis of the volume data selected in the data selection process S21, is different from the standard temperature Tn, wherein creating the time-volume profile S22 creates a time-volume profile corresponding to the volume corrected by the correcting a volume S23.

In an exemplary embodiment of the present invention, the pouch-type battery cell may have a structure in which an electrode assembly containing a positive electrode, a negative electrode, and a separator is accommodated inside a battery case of a laminate sheet, and the battery case is sealed by heat fusion, and the data collection process S10 may include converting a received signal to a volume change of the battery cell using any one of a thermal imaging camera, a strain gauge, and a pressure sensor.

### [Advantageous Effects]

Since the fused state of a sealing part of a pouch-type battery cell is released when a volume change in a time-volume profile of a battery cell is converted from a stagnant state to an increasing state, a battery module according to the present invention is configured to recognize this as a gas venting risk point, allowing a risk of gas venting to be detected before a gap occurs in the sealing part or when a gap is about to occur in the sealing part, thereby having an effect of improving performance and safety of a battery module.

### [Brief Description of the Drawings]

FIG. 1 is a schematic diagram of a pouch-type battery cell.
FIG. 2 is an exploded perspective view of a battery module according to an exemplary embodiment of the present invention.
FIG. 3 is a schematic diagram showing a volume change behavior of a battery cell included in a battery module.
FIG. 4 is a schematic diagram showing a volume change behavior of a battery cell included in a battery module by each section.
FIG. 5 is an exploded perspective view of a battery module according to another exemplary embodiment of the present invention.
FIG. 6 is a schematic diagram of a strain gauge.
FIG. 7 is a diagram showing various embodiments in which a strain gauge is attached to a battery cell.
FIG. 8 is a flow chart of a method for detecting a gas venting risk point according to the present invention.
FIG. 9 is a time-volume profile created according to an exemplary embodiment of the present invention.

### [Best Mode for Carrying Out the invention]

Since the present invention can apply various modifications and have various embodiments, specific exemplary embodiments will be exemplified and described in detail in the description. However, it should be understood that the present invention is not limited to specific embodiments, and includes all modifications, equivalents or alternatives within the spirit and technical scope of the present invention.

The terms "comprise" or "have" are used herein to designate the presence of characteristics, numbers, steps, actions, components or members described in the specification or a combination thereof, and it should be understood that the possibility of the presence or addition of one or more other characteristics, numbers, steps, actions, components, members or a combination thereof is not excluded in advance. In addition, when a part of a layer, a film, a region or a plate is disposed "on" another part, this includes not only a case in which one part is disposed "directly on" another part, but a case in which a third part is interposed therebetween. In contrast, when a part of a layer, a film, a region or a plate is disposed "under" another part, this includes not only a case in which one part is disposed "directly under" another part, but a case in which a third part is interposed therebetween. In addition, in this application, "on" may include not only a case of disposed on an upper part but also a case of disposed on a lower part.

Hereinafter, the present invention will be explained in detail.

### Battery Module

A battery module according to the present invention includes: a battery cell stack in which a plurality of battery cells is stacked; a measuring part including a volume measuring means for observing a volume change of a battery cell, and transmitting the observed volume change as a signal; and a control part receiving a signal from the measuring part, creating a time-volume profile representing volume change over time, and recognizing the risk of gas venting, wherein the control part is configured to recognize the time when the volume change in the time-volume profile converts again from a stagnant state to an increasing state as a gas venting risk point.

The battery cell is a pouch-type battery cell, and the pouch-type battery cell has a structure in which an electrode assembly including a positive electrode, a negative electrode, and a separator is accommodated inside a battery case of a laminate sheet, and the battery case is sealed by heat fusion.

Referring to FIG. 1, the pouch-type battery cell 10 has a structure in which two electrode leads 40, 41 electrically connected to positive electrode and negative electrode tabs 31, 32 of an electrode assembly 30 composed of a positive electrode, a negative electrode, and a separator disposed therebetween inside a pouch-type battery case 20 are sealed so that they are exposed to an outside.

A battery case 20 may be composed of a case body 21 provided with a concave shape accommodation part 23 in which the electrode assembly 30 can be seated, and a cover 22 integrally connected to the body 21.

When sealing the pouch-type battery cell 10, the case body 21 and the cover 22 are heat-compressed together while in contact with each other using a sealing member, and during heat-compression, a polymer resin constituting the innermost coating layer of the aluminum laminate sheet constituting the body 21 and the cover 22 is melted, and thus the body 21 and the cover 22 are fused. And the portion heat-fused by heat-compression of the sealing member is referred to as a sealing part.

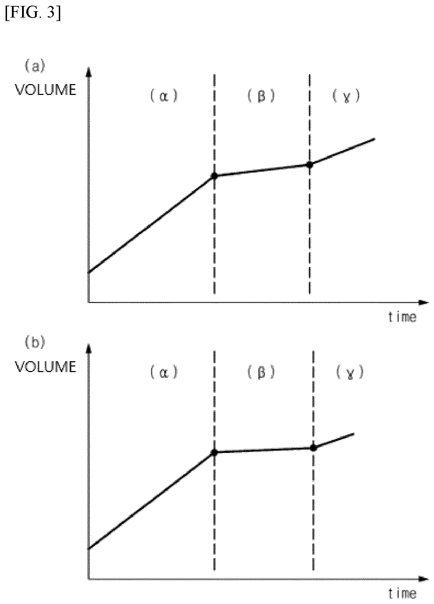

Such a pouch-type battery cell 10 has a constant pattern of volume change according to the years of use. FIG. 3 is a schematic diagram showing a volume change behavior of a battery cell accommodated in a battery module. Referring to FIG. 3, the volume of the battery cell initially tends to increase, but when a certain volume is reached, the increase in volume of the battery cell tends to stagnate. Initially, the internal gas generated in the battery fills the empty space inside the battery cell, and increases the volume of the battery cell, but when the battery cell reaches a certain volume, due to the limited space inside the battery cell, it becomes difficult for the volume of the battery cell to increase. However, since gas is continuously generated inside the battery cell, and this gas increases the internal pressure of the battery, the pressure inside the battery continuously increases even when the volume change is stagnant when viewed from the outside. That is, in the volume change behavior shown in FIG. 3, a section in which the volume increase is stagnant may be a section in which an increase in internal pressure is accumulated.

When this stagnant section progresses to some extent, a tendency for the volume of the battery cell to increase again is observed. When the tendency for the volume to increase again begins to appear, it may be the time when the sealing part of the pouch-type battery cell starts to open. Opening of the sealing part means that the body 21 and the cover 22 are separated due to a release in the fused state of the sealing part in which the main body 21 and the cover 22 were heat-fused. In addition, when the sealing part opening phenomenon intensifies, a gap is generated in the sealing part connecting the inside and outside of the battery, and an electrolyte leaks or a gas is vented through the gap, which negatively affects the performance and safety of the battery cell.

Therefore, in the present invention, the volume measuring means included in the measuring part observe the volume change of the battery cell, and the control part creates a time-volume profile representing volume change over time based on the volume change signal received from the measuring part.

In addition, the control part recognizes the time when the volume change in the time-volume profile converts again from a stagnant state to an increasing state as a time when a fused state of each sealing part of the body 21 and the cover 22 starting to be released, thus considering this as a gas venting risk point. Accordingly, the battery module of the present invention has an effect of improving the performance and the safety of the battery module by recognizing the risk of gas venting when gas venting is imminent.

### <First Embodiment>

FIG. 2 is a schematic diagram of a battery module according to an exemplary embodiment of the present invention. Referring to FIG. 2, the battery module 100 according to the present invention includes a battery cell stack 110, a measuring part 120, and a control part 130.

The battery cell stack 110 is formed by stacking a plurality of battery cells 10. The battery cell 10 is the pouch-type battery cell described above, and due to the material characteristics of the battery case, when internal gas is generated, the change in volume of the battery cell is immediately observed, so it is suitable as a battery cell included in the battery module of the present invention. Meanwhile, a prismatic or a cylindrical battery in which a battery case is a metal can is not suitable as a battery cell included in the battery module of the present invention because it is difficult to immediately observe the change in volume of the battery cell when internal gas is generated due to the material characteristics of the battery case.

In addition, the battery cell 10 may be a high-capacity battery applicable to automobiles, ESS, and the like. Specifically, the capacity of the battery cell 10 may range from 30Ah to 150Ah. Since such a high-capacity battery cell 10 generates a large amount of internal gas, it may lead to a major accident when gas is vented, but the battery module of the present invention can detect gas venting before or at the beginning of gas venting, so it is particularly useful for a high-capacity battery cell.

The measuring part 120 may include a volume measuring means for observing a volume change of the battery cell 10, and may be configured to transmit the observed volume change to the control part 130 as a signal.

In one specific example, the measuring part 120 may include a thermal imaging camera as a volume measuring means for observing a volume change in the battery cell 10. The thermal imaging camera may be configured to perform a vision inspection on a sealing portion heat-fused to the battery case of the pouch-type battery cell 10.

In terms of the structure of the battery module, in a structure in which the battery cell stack 110 is open, the thermal imaging camera can easily observe the volume change of the battery cell 10 or the battery cell stack 110.

When the volume measuring means is a thermal imaging camera, the control part 130 may include a calculation part entered a calculation program for estimating the volume change of the battery cell from the battery cell image received from the camera. Such calculation program can estimate the volume change through the number of pixels displayed in the battery cell image. Also, the control part may create a time-volume profile representing the change in volume over time based on such volume change.

It is preferable that such thermal imaging camera be disposed in the periphery of the sealing part so as to be able to perform vision inspection on the sealing part of the battery cell.

In addition, in the present invention, if gas venting occurs even in one battery cell among the battery cell stack, the performance and the safety of the battery module may be affected, so it is desirable that the thermal imaging camera can observe the volume of each battery cell constituting the battery cell stack.

The control part 130 receives a signal from the measuring part 120, creates a time-volume profile representing a volume change over time based on the received signal, and determines the risk of gas venting. In addition, the control part determines the time when the volume change in the time-volume profile converts again from a stagnant state to an increasing state as a gas venting risk point.

A time-volume profile according to one specific example may have a graph overview shown in FIG. 3.

Hereinafter, the technical background of determining the time when the volume change in the time-volume profile converts again from a stagnant state to an increasing state as a gas venting risk point will be described in detail with reference to the drawings.

Referring to FIG. 3, the time-volume profile created by the control part may be divided into a first section α in which the volume increases, a second section β in which the volume change stagnates following the first section, and a third section γ in which the volume change increases again following the second section.

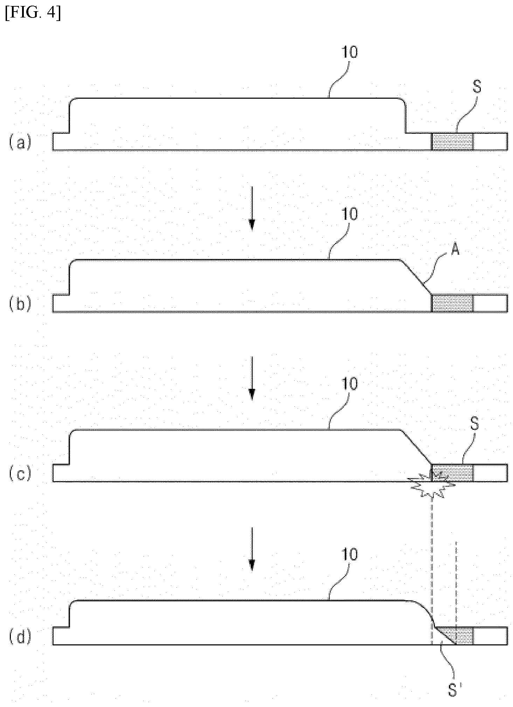

FIG. 4 is a cross-sectional view of a battery cell showing a volume change behavior of a battery cell for each section. FIG. 4(a) to FIG. 4(b) is showing the battery cells of the first section, FIG. 4(b) to FIG. 4(c) is showing the battery cells of the second section, and FIG. 4(c) to FIG. 4(d) is showing the battery cells of the third section.

The first section α, which is an initial section, is a section in which the volume of a battery cell continuously increases. As the battery cell is used, the amount of internal gas generated increases, and the volume of the electrode itself may expand. Thus, in the initial sections of the time-volume profile, a behavior in which the volume of the battery cell continuously increases is shown.

The first section is a section in which the volume of the battery cell increases while the gas inside the battery cell 10 occupies the empty space inside the battery cell. In the first section, as shown in FIG. 4(a) to FIG. 4(b), the volume of the battery cell 10 increases.

When the volume of the battery cell 10 increases to a certain level as shown in FIG. 4(b), since the space inside the battery case is limited, the time-volume profile enters the second section β in which the volume change of the battery cell stagnates. The second section is a section in which the increase in volume is stagnant, and externally, while the change in volume of the battery cell seems to be stagnant, the increase in internal pressure may be continuously accumulating.

As shown in FIG. 3(a), the graph overview of such second section β may have a slope of the volume change much smaller than the slope of the volume change in the first section. Also, as shown in FIG. 3(b), in the graph overview of the second section, the slope of the volume change in the second section β may be close to zero.

As shown in FIG. 4(b) to FIG, 4(c), in the second section β, the battery cell 10 may not externally increase in volume.

In addition, when the state in the second section β continues to some extent, the internal pressure of the battery cell is accumulated, and the accumulated internal pressure can gradually release the fused state of the sealing part of the battery cell. Then, as the sealing part that has been fused opens, a gap formed by the opening is filled with internal gas, and thus entering the third section γ in which the volume of the battery cell starts back to increase. The third section is a section in which the volume of the battery cell 10 increases again following the second section, and as shown in FIG. 4(c) to FIG. 4(d), the battery cell 10 in the third section γ has its sealing part S opened, and the internal gas is introduced into the space S' within the opened sealing part, thereby causing an increase in the volume of the battery cell.

Accordingly, the control part 130 of the present invention determines the starting point of the third section as the gas venting risk point. The beginning of the third section is a section in which internal gas is introduced into the inner space formed by the opening of the fused sealing part, and while gas venting has not actually begun, it is a period in which gas venting is imminent, so the battery module of the present invention has an effect of detecting the risk of gas venting when gas venting is imminent.

Meanwhile, the amount of gas generated by the battery cell 10 is affected by the state of charge (SOC) of the battery cell and the temperature of the battery cell. Even if a battery cell has the same period of use, the amount of gas generated varies depending on the state of charge and temperature of the battery cell, so the volume of the battery cell is also affected.

That is, even if the battery cell has the same period of use, there may be a difference between the volume of the battery cell when the state of charge of the battery cell is fully charged (SOC 100%) and the volume of the battery cell when the state of charge of the battery cell is fully discharged (SOC 0%).

In addition, even if the battery cell has the same period of use and state of charge, the volume of the battery cell may be different when the temperature is high and low, respectively.

Accordingly, the control part 130 of the present invention may be configured to create a time-volume profile by reflecting the volume difference of the battery cell according to the difference in state of charge, and the volume difference of the battery cell according to the temperature difference of the battery cell.

During use of the battery cell, since the battery cell is repeatedly charged and discharged, the state of charge (SOC) of the battery cell is not constant and continuously changes over time. Therefore, in order to accurately compare the battery cell volume, the battery cell volume should be compared based on the volume of the battery cell in a constant state of charge.

Accordingly, the volume that is the basis of the time-volume profile of the present invention may be the volume of the battery cell when the state of charge of the battery cell satisfies the set SOC value. That is, the control part 130 of the present invention may be configured to create the time-volume profile based on the volume when the state of charge (SOC) of the battery cell satisfies the set SOC value.

The set value of the SOC, which is the basis for the volume measurement, is not particularly limited, and in one specific example, the set SOC may be the SOC of the battery cell when the volume of the battery cell is first measured. In this case, there is an advantage in that the volume change can be observed from the beginning of the battery cell use.

In another specific example, the set SOC may be a value selected from the range of SOC 0% to SOC 20%. In the battery cell, as the state of charge level increases, the amount of gas generated increases, and thus the volume of the battery cell increases. Since the volume increasing effect according the state of charge can be excluded as the battery cell is in a discharged state or close to a discharged state, and since the time-volume profile created based on the volume of the battery cell in the state of charge selected in the above range has a great discriminating effect from the first section to the third section, the point of the third section can be more accurately detected.

In this case, in order to know the state of charge (SOC) of the battery cell, besides the volume measuring means, the measuring part 120 may further include a means for measuring the SOC of the battery cell. As a specific example of the volume measuring means, a voltage sensor for measuring the voltage of a battery cell may be exemplified.

Meanwhile, even if a time-volume profile is created based on the volume of a battery cell measured when a specific SOC is satisfied as above, in order to more accurately compare the volume, the volume difference according to the temperature difference in the time-volume profile needs to be reflected.

Accordingly, the control part 130 according to an exemplary embodiment of the present invention corrects the volume Vm measured at the actual volume measurement temperature Tm to the volume Vn at the standard temperature Tn, and it may be configured to create the time-volume profile based on the corrected volume Vn.

For example, at a certain point in time T1, when the volume measurement temperature of a battery cell with an SOC of 10% is 23°C, and at a certain point in time T2, when the volume measurement temperature of a battery cell with an SOC of 10% is 28 °C, it is necessary to correct the volume difference according to the temperature difference when measuring the volume.

The control part 130 of the present invention may be entered with a correction formula for correcting the volume difference according to the temperature difference, and the control part 130 may substitute the volume measurement temperature Tn, the measured volume value Vm at the measurement temperature Tn, and the standard temperature Tn to such correction formula to calculate the volume Vn at the standard temperature Tn. In addition, by creating a time-volume profile based on such calculated volume Vn, the volume change due to the temperature difference can be corrected. Accordingly, the control part has an effect of being able to more accurately compare the volume change.

The correction formula may be derived through a regression analysis of back data representing a correlation between temperature and volume of a battery cell in advance, or a deep learning.

In this case, in order to know the volume measurement temperature of the battery cell, besides the volume measuring means, the measuring part 120 may further include a temperature sensor for measuring the temperature of the battery cell. A specific example of such a temperature sensor may be a thermocouple sensor.

In one specific example, the control part 130 may be a BMS (Battery Management System) that monitors and controls the operation of the battery module.

In addition, the control part 130 of the present invention may generate a warning signal to secure the safety of the battery module when recognizing the risk of gas venting.

In one specific example, the warning signal may be an operation control signal for stopping the operation of the battery module. In another specific example, the warning signal may be a recognition signal that visually or aurally makes a user or a mechanic of a device equipped with a battery module recognize the danger.

### <Second Embodiment>

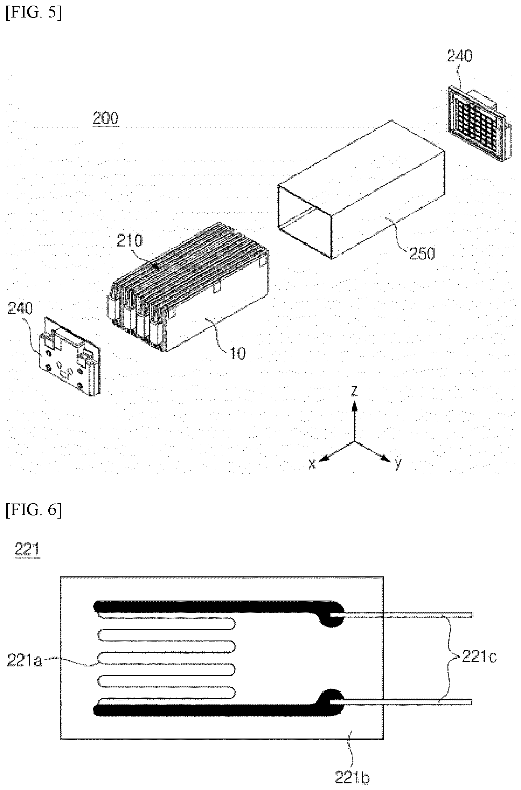

FIG. 5 illustrates a battery module according to another exemplary embodiment of the present invention, and FIG. 6 is a diagram showing a part of a battery module. Referring to these drawings, the battery module 200 according to an exemplary embodiment of the present invention includes a battery cell stack 210, a measuring part, a control part, and a module case 250.

Compared to the battery module 100 according to the first embodiment, the battery module 200 according to the second embodiment further includes a module case 250, so that there is a difference in that the battery cell stack 210 is not open, and has a closed structure by an end plate 240 and the module case 250.

The module case 250 has an accommodation space corresponding to the shape and size of the battery cell stack 210 therein. The module case 250 may have a hexahedral shape, and may have an open part in which a pair of surfaces facing each other is open. The battery cell stack 210 can be inserted into the module case 250 through the open part. The open part may have an end plate 240 coupled thereto, and may have a closed structure by a coupling between the end plate 240 and the module case 250.

In a battery module having a closed structure, even if a thermal imaging camera is installed inside the battery module, it may be impossible or extremely difficult to observe a volume change of the battery cell through vision inspection.

Therefore, if the battery module has a closed structure by an exterior material such as the module case 250, etc., a strain gauge or a pressure sensor may be preferable as a volume measuring means for observing the volume of the battery cell 10.

A strain gauge may be a means for detecting a minute change in mechanical stress as an electrical signal. FIG. 6 is a schematic diagram of a strain gauge. Referring to FIG. 6, the strain gauge 221 includes a stress-sensing resistor 221a that senses stress by arranging several thin wires in one direction and connecting them in series, an insulating sheet 221c that insulates between a stress-sensing resistor 221b and an object to be measured, and a conducting wire 221d for transmitting the measured electrical signal, and a coating layer (not shown) may be formed to protect the stress-sensing resistor 221b from an external damage.

The strain gauge may be composed of a Wheatstone bridge circuit that can efficiently convert an electrical signal output as a change in electrical resistance.

When the volume of the battery cell expands, a stress change is applied to the outer surface of the battery case to which the strain gauge is attached, and the strain gauge detects this and generates an electrical signal (change in resistance) according to the stress change. This electrical signal is transmitted to a detecting means (not shown), an output voltage is generated according to a change in the electrical signal, and the output voltage is amplified by an additionally provided amplifier to output the amplified voltage. Since the control part 230 includes a calculating part for estimating the voltage signal received from the strain gauge as the volume of the battery cell, it may calculate the volume change of the battery cell.

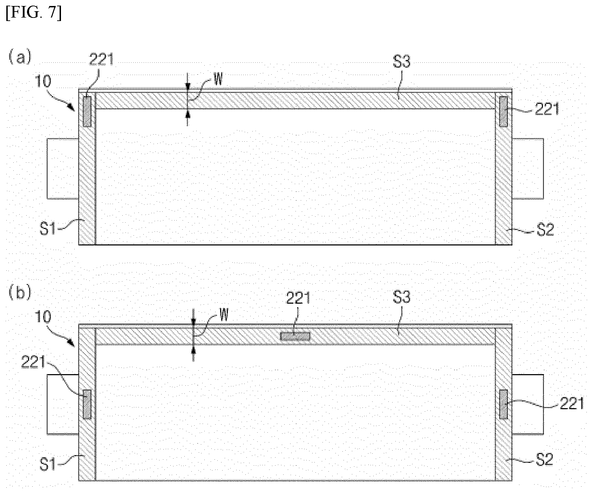

FIG. 7 is a diagram showing various embodiments in which strain gauges are attached to a battery cell 10. Referring to FIG. 7, the strain gauge 221 may be attached to sealing parts S1 to S3 in which the battery case is heat-fused. The sealing parts S1 to S3 have a predetermined width W, are formed along the corner part of the battery cell 10, and may include a first sealing part (S1) formed in the left corner part of the battery cell 10, a second sealing part S2 formed on the right corner part of the battery cell 10, and a third sealing part S3 formed on the upper corner part of the battery cell 10.

One strain gauge 221 may be attached, or two or more may be attached. As shown in FIG. 7 (a), the strain gauge 221 may be attached to a region where the first sealing part S1 and the third sealing part S3 intersect, and a region where the second sealing part S2 and the third sealing part S3 intersect, respectively. In addition, as shown in FIG. 7(b), the strain gauge 221 may be attached to the center of the first sealing part S 1, the center of the second sealing part S2, and the center of the third sealing part S3, respectively.

When a plurality of strain gauges 221 is attached to a single battery cell 10, the volume of the battery cell 10 can be estimated using an average value or a median value.

Within the battery cell stack 210, if gas venting occurs in even one battery cell, it may affect the performance and safety of the battery module, so it is preferable that the strain gauge 221 is attached correspondingly to each of the plurality of battery cells 10 so that all of the battery cells 10 constituting the battery cell stack 210 can be individually monitored.

The pressure sensor may be capable of detecting a change in internal pressure of the battery cell 10. As described above, the volume of the battery cell 10 initially increases, but when it reaches a certain volume, a section in which the volume increase stagnates appears, and when this stagnant section reaches a limit, the internal pressure of the battery cell acts on the sealing part of the battery cell, and thus the sealing part is opened. The pressure sensor is preferably installed so that it is in close contact with the sealing part where the battery case is heat-fused, in order to detect when the volume of the battery cell increases again as the sealing part opens.

Meanwhile, since the contents of each component of the battery cell stack 210, the measuring part, and the control part 230 have been described in detail above, descriptions thereof will be omitted.

The battery pack according to the present invention includes one or more of the above-described battery modules as unit modules. Accordingly, the battery pack according to the present invention can improve safety by early-detecting a venting of a battery cell.

### Method for detecting gas venting risk point

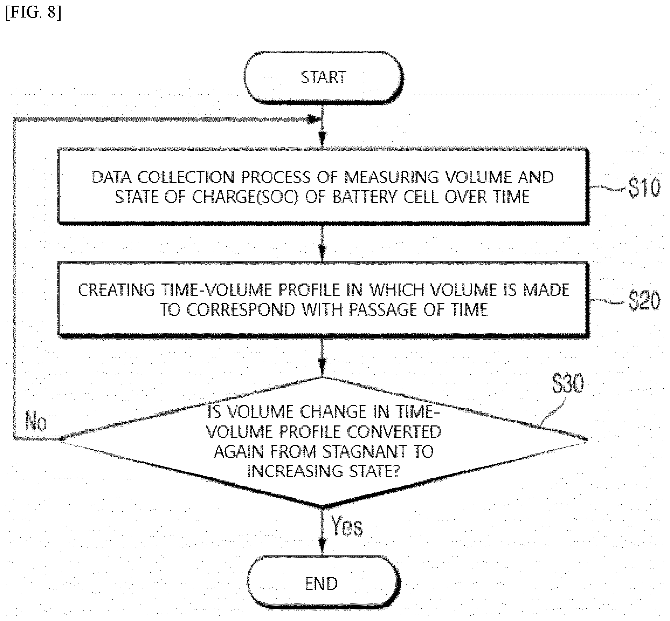

FIG. 8 is a flowchart of a method for detecting a gas venting risk point according to the present invention. Referring to FIG. 8, the method for detecting the risk of gas venting according to the present invention is a method for detecting the risk of gas venting of a pouch-type battery cell, including: a data collection process S10 of measuring the volume change of the battery cell over time, and the state of charge (SOC) of the battery cell; creating a time-volume profile corresponding to volume over time S20; and determining the time when the volume change in the time-volume profile converts again from a stagnant state to an increasing state as a gas venting risk point S30.

The data collection process S10 is a process of measuring the volume of the battery cell and the state of charge of the battery cell in real time for the battery cell in use, and it is a process of collecting volume data that becomes a data for determining the gas venting risk point.

A method of measuring the volume of the battery cell is not particularly limited as long as it is a method capable of figuring out the volume change of the battery cell. Specifically, methods such as using a means that can directly measure the volume change of the battery cell, estimating the volume change by analyzing an image obtained by the above-described thermal imaging camera, or estimating the voltage signal obtained by a strain gauge as the volume change can be used.

In addition, since the volume of the battery cell is affected by the temperature, in order to accurately compare the volume change, the data collection process S10 may further include a process of measuring the temperature of the battery cell.

In order to grasp the behavior of the volume change in the data collected and accumulated by the data collection process S10, the process of creating a time-volume profile S20 is a process of creating a graph in which the volume or the volume change of the battery cell is made to correspond with the passage of time. Here, the volume change may be a value obtained by subtracting the volume of the initial battery cell from the volume of the battery cell measured at an arbitrary time point.

Meanwhile, the amount of gas generated by the battery cell is affected by the state of charge (SOC) of the battery cell. Even if the battery cell has the same period of use, the amount of gas generated varies depending on the state of charge of the battery cell, and thus the volume of the battery cell is also affected. That is, even if the battery cell has the same period of use, the volume of the battery cell when the state of charge of the battery cell is fully charged (SOC 100%) and the volume of the battery cell when the state of charge of the battery cell is fully discharged (SOC 0%) may be different.

Therefore, in order to reflect the volume difference of the battery cell according to the difference in the state of charge of the battery cell, creating the time-volume profile S20 may include: selecting S21 the volume data of the battery cell measured when the state of charge (SOC) of the battery cell is a set SOC; and creating a time-volume profile S22 by making the selected volume data to correspond with the passage of time.

During use of a battery cell, since the battery cell is repeatedly charged and discharged, the state of charge (SOC) of the battery cell is not constant and continuously changes over time. Therefore, in order to accurately compare the battery cell volume, the battery cell volume should be compared based on the volume of the battery cell in a constant state of charge.

Accordingly, the volume that is the basis of the time-volume profile of the present invention may be the volume of the battery cell when the state of charge of the battery cell satisfies the set SOC value. That is, among the volume data measured in various state of charges, the selection process S21 selects the volume data when the state of charge (SOC) of the battery cell satisfies the set SOC value, and with the selected volume data, creates the volume profile over time. For example, if the set SOC is 5%, volume data measured when the state of charge (SOC) of the battery cell is SOC 5% is selected.

And the range of the set SOC value may be a value selected from the range of SOC 0% to SOC 20%. In the battery cell, as the level of state of charge increases, the amount of gas generated increases, and thus the volume of the battery cell increases. If the battery cell is in a discharge state or close to the discharge state, the volume increasing effect due to the state of charge can be excluded, so a time-volume profile created based on the volume of the battery cell in the state of charge selected in the above range can more accurately detect when the volume change converts again from a stagnant state to an increasing state.

Meanwhile, even if a time-volume profile is created based on the volume of a battery cell measured when a specific SOC is satisfied as described above, in order to more accurately compare volumes, the volume difference due to the temperature difference needs to be reflected in the time-volume profile.

Therefore, when the volume measurement temperature Tm, which is the basis of the volume data selected in the data selection process S21, is different from the standard temperature Tn, the process of creating the time-volume profile S20 may further include a volume correction process S23 of correcting the selected volume data to a volume at the standard temperature Tn, and creating the time-volume profile S22 may be a process of creating a time-volume profile corresponding with the volume corrected by the volume correction process S23.

In one specific example, the volume correction process S23 uses a correction formula for correcting the volume difference according to the temperature difference. The volume measurement temperature Tn of the battery cell, the measured volume value Vm in the measurement temperature Tn, and the standard temperature Tn are substituted into the correction formula to calculate the volume Vn at the standard temperature Tn. Furthermore, creating the time-volume profile S22 may be a process of creating the time-volume profile using the volume Vn at the standard temperature Tn calculated by the volume correction process S23. Accordingly, there is an effect of being able to more accurately compare the volume change.

The correction formula may be derived through a regression analysis of back data representing a correlation between temperature and volume of a battery cell in advance or through a deep learning.

The determination process S30 is a process of determining the time when the volume change in the time-volume profile created by the time-volume profile creation process S20 converts again from a stagnant state to an increasing state as the gas venting risk point.

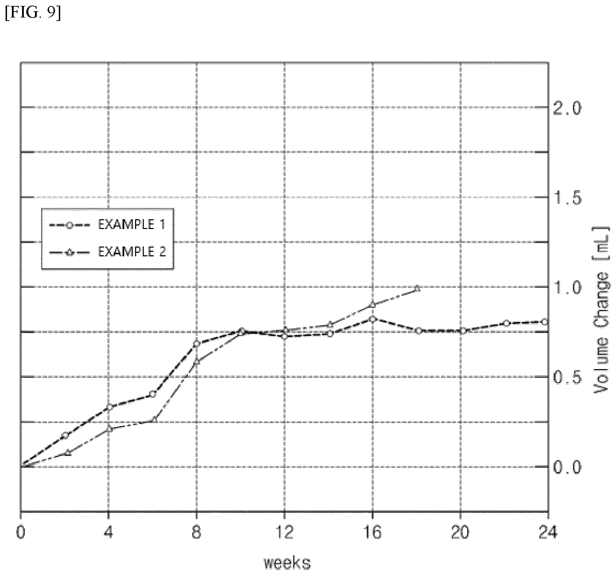

FIG. 9 is a time-volume profile created according to an exemplary embodiment of the present invention. The volume change of the Y-axis in the profile of FIG. 9 is a value obtained by subtracting the initial volume of the battery cell from the volume of the battery cell at the time of measuring the volume.

Referring to FIG. 9, the time-volume profile according to Example 1 shows that the volume of the battery cell continuously increases until about week 8, and then the volume increase becomes stagnant. It can be determined that the gas venting risk is not imminent in the battery of Example 1.

In the time-volume profile according to Example 2, the volume of the battery cell continuously increases until about week 9, the increase in volume stagnates between about week 9 and about week 14, and then the volume increases again. It can be determined that the gas venting risk is imminent in the battery of Example 2 at about week 14.

The present invention is not limited to the above-described embodiments, and the scope of application is diverse, and anyone with an ordinary knowledge in the field to which the present invention belongs can make various modifications without departing from the subject matter of the present invention claimed in the claims.

## Claims

1. A battery module, comprising:
a battery cell stack in which a plurality of battery cells is stacked;
a measuring part including a volume measuring means for observing a volume change of a battery cell, and transmitting the observed volume change as a signal; and
a control part receiving a signal from the measuring part, creating a time-volume profile representing volume change over time based on the received signal, and recognizing the risk of gas venting, wherein
the control part is configured to recognize the time when the volume change in the time-volume profile converts again from a stagnant state to an increasing state as a gas venting risk point.

2. The battery module of claim 1, wherein
the time-volume profile is divided into a first section in which the volume increases, a second section in which the volume change stagnates following the first section, and a third section in which the volume change increases again following the second section, wherein
the control part recognizes the starting point of the third section as a gas venting risk point.

3. The battery module of claim 1, wherein
the control part is configured to create the time-volume profile based on a volume when a state of charge (SOC) of a battery cell satisfies a set SOC value.

4. The battery module of claim 1, wherein
the control part is configured to correct a volume Vm measured at an actual volume measurement temperature Tm with a volume Vn at a standard temperature Tn, and create the time-volume profile based on the corrected volume Vn.

5. The battery module of claim 1, wherein
the battery cell is a pouch-type battery cell having a structure in which an electrode assembly comprising a positive electrode, a negative electrode, and a separator is accommodated inside a battery case of a laminate sheet, and the battery case is sealed by heat fusion.

6. The battery module of claim 5, wherein
the volume measuring means comprises a thermal imaging camera configured to perform a vision inspection on a sealing part in which the battery case is heat-fused.

7. The battery module of claim 5, further comprising
a module case which has an accommodation space corresponding to the shape and size of a battery cell stack inside, and is hexahedron-shaped.

8. The battery module of claim 7, wherein
the volume measuring means is either a strain gauge or a pressure sensor.

9. The battery module of any one of claims 6 or 8, wherein
the control part comprises a calculation part for estimating a signal received from the measuring part as a volume change.

10. The battery module of claim 8, wherein
the strain gauge is attached to a sealing part in which a battery case is heat-fused.

11. The battery module of claim 1, wherein
the measuring part further comprises:
a voltage sensor for measuring the voltage of a battery cell; and
a temperature sensor for measuring the temperature of the battery cell.

12. The battery module of claim 1, wherein
the control part is configured to generate a warning signal to secure the safety of the battery module when recognizing the risk of gas venting, and
the warning signal is any one or more of (1) an operation control signal for stopping the operation of the battery module, (2) a recognition signal that visually or aurally makes the user or the mechanic of a device equipped with a battery module aware of the danger.

13. A battery pack comprising one or more battery modules of claim 1 as a unit module.

14. A detection method of gas venting risk point for detecting a gas venting risk of a pouch-type battery cell, comprising:
a data collection process S 10 of measuring a volume change of the battery cell and a state of charge (SOC) of the battery cell over time;
creating a time-volume profile S20 in which volume is made to correspond with the passage of time; and
determining S30 the time when the volume change in the time-volume profile converts again from a stagnant state to an increasing state as a gas venting risk point.

15. The detection method of gas venting risk point of claim 14, wherein
creating a time-volume profile S20, comprising:
selecting S21 a measured volume data of a battery cell when a state of charge (SOC) of a battery cell is a set SOC; and
creating a time-volume profile S22 by matching the selected volume data to the passage of time.

16. The detection method of gas venting risk point of claim 14, wherein
the data collection process S10 further comprises measuring a temperature of a battery cell, and
the creating a time-volume profile S20 further comprises correcting a volume S23 in which the selected volume data is corrected to a volume at the standard temperature Tn when the volume measurement temperature Tm, which is the basis of the volume data selected in the data selection process S21, is different from the standard temperature Tn, wherein
the creating a time-volume profile S22 creates a time-volume profile corresponding to the volume corrected by the correcting a volume S23.

17. The detection method of gas venting risk point of claim 14, wherein
the pouch-type battery cell has a structure in which an electrode assembly containing a positive electrode, a negative electrode, and a separator is accommodated inside a battery case of a laminate sheet, and the battery case is sealed by heat fusion, and
the data collection process S 10 comprises converting a received signal to a volume change of the battery cell using any one of a thermal imaging camera, a strain gauge, and a pressure sensor.
